# EUROPEAN PATENT SPECIFICATION

(11) **EP 0 550 119 B1**
(45) Date of publication and mention of the grant of the patent: **18.12.1996**
(21) Application number: 92300001.2
(22) Date of filing: 02.01.1992
(51) Int. Cl.: G03F 7/18, B05C 1/02

(54) **A device for coating a photosensitive film on a plate roll**
Vorrichtung zur Beschichtung eines lichtempfindlichen Films auf einem Plattenzylinder
Appareil pour enduire un film photosensible sur un cylindre de plaque

(43) Date of publication of application: 07.07.1993
(73) Proprietor: THINK LABORATORY CO., LTD., Kashiwa-shi Chiba-ken 277 (JP)
(72) Inventor: Shigeta, Tatsuo, Kashiwa-Shi, Chiba-Ken, 277 (JP)
(74) Representative: Thomson, Paul Anthony

(56) References cited:
- US-A- 2 701 543
- US-A- 2 766 719
- US-A- 4 275 097

## Description

### BACKGROUND OF THE INVENTION

### 1. Field of the Invention

The present invention relates to a device for coating a photosensitive film on a printing plate shaped in a roll (hereinafter called a "plate roll") and more specifically to a device wherein a pretreatment, a photosensitive film coating treatment and a protective film coating treatment are successively performed on the plate roll by a single device.

### 2. Prior Art

Generally, in a plate making process for a plate roll, steps of BALLARD COPPER plating, buffing, pretreatment, photosensitive film coating, protective film coating, argon ion laser exposure, development, etching, resist stripping, and chrome plating are successively performed in the order listed.

In this processes, the protective film coating is performed for the following reasons: since the photosensitive film uses an ultra-high-sensitivity photosensitive agent which can be exposed by means of an argon ion laser, the photosensitive film is susceptible to oxidation in a short period of time after it is coated. If the photosensitive film is oxidized, the film loses its photosensitivity. Furthermore, if the photosensitive film is exposed in the open air, the oxygen in the air hinders the photosensitive performance of the photosensitive agent.

As is mentioned above, the plate making process is comprised of several different steps, and these steps are performed by devices which are lined up independently.

In other words, to make a plate roll, several devices are required. Therefore, the conventional devices occupy large spaces, and the cost of the devices used for plate making are high. Furthermore, handling of the product between the various devices requires considerable time and labor. Moreover, since the pretreatment is conventionally performed by hand, it is desirable that the pretreatment is integrated with the photosensitive film coating device.

### SUMMARY OF THE INVENTION

Accordingly, the object of the present invention is to provide a photosensitive film coating device for plate rolls, in which a pretreatment, a photosensitive film coating treatment and a protective film coating treatment are successively performed on the plate roll by means of a single device.

As a means to solve the above described problems, the present invention provides a photosensitive film coating device for plate rolls, which is characterized by the fact that:
a plate roll is held and rotated by a roll chucking means that is comprised of a spindle chuck, a tail chuck, and motors, and the plate roll is treated by a multi-treatment means comprised of a pretreatment means, a photosensitive film coating means and a protective film coating means which are respectively provided on three separate table devices that can be raised and lowered relative to the plate roll.

The three separate table devices are installed on a common table which is provided on a flame of the photosensitive film coating device so as to be slid along the axis of the plate roll, wherein:
the pretreatment means includes a cleaning means, a rinsing means, and a moisture removal means, and consecutively cleans the plate roll, rinses the plate roll, and then removes moisture from the plate roll;
the photosensitive film coating means consists of a photosensitive film coating roll and a photosensitive liquid tank, and applies photosensitive liquid on the plate roll following the pretreatment operation performed by the pretreatment means, and
the protective film coating means consists of a protective film coating roll and a protective liquid tank, and applies protective liquid on the plate roll following the photosensitive liquid coating operation performed by the photosensitive film coating means.

In the photosensitive film coating device described above:
the plate roll is first horizontally held by the chuck means and rotated at a predetermined speed,
the separate table including the pretreatment means is raised so that the first brush of the pretreatment means makes contact with the surface of the plate roll, and
the common table then slides along the axis of the plate roll.

As a result, the second brush and the sponge roll consecutively come into contact with the surface of the plate roll. The cleaning, the rinsing and the moisture removing are thus performed successively.

After the pretreatment is thus finished, the separate table including the pretreatment means is lowered, and the common table is reversely slid so that the common table reaches at the initial position of the photosensitive film coating process.

Next, the separate table including the photosensitive film coating means is raised to the plate roll so that the photosensitive film coating roll contacts the surface of the plate roll, and the common table is slid in the axial direction of the plate roll.

As a result, a photosensitive film is applied on the surface of the plate roll. After the photosensitive film coating is finished, the separate table including the photosensitive film coating means is lowered, and the common table is reversely slid so that the common table reaches the initial position of the protective film coating process.

Next, the separate table, including the protective film coating, is raised to the plate roll so that the protective film coating roll contacts the surface of the plate roll, and the common table is slid along the axis of the plate roll.

As a result, a protective film is applied on the surface of the plate roll. After the protective film coating process is finished, the separate table including the protective film coating means is lowered, and the common table is reversely slid so that the common table reaches the initial position of the pretreatment process.

As is mentioned above, three different steps of the plate making process are performed by a single device. Thus, the plate roll making device of the present invention does not occupy large spaces. Furthermore, handling of the products between the devices can be decreased, so that the plate roll is made at a low price.

### BRIEF DESCRIPTION OF THE DRAWINGS

Figure 1 is a schematic front view which illustrates one embodiment of the photosensitive film coating device for plate rolls of the present invention, especially showing a pretreatment process;
Figure 2 is a schematic front view thereof, showing the photosensitive film coating process;
Figure 3 is a schematic front view thereof, showing the protective film coating process;
Figure 4 is an enlarged front view of the essential parts illustrating the pretreatment process;
Figure 5 is an enlarged front view of the essential parts illustrating the photosensitive film coating process; and
Figure 6 is an enlarged front view of the essential parts illustrating the protective film coating process.

### DETAILED DESCRIPTION OF THE INVENTION

Below, an embodiment of the present invention will be described with reference to the attached drawings.

First, a constitution of the device will be described:

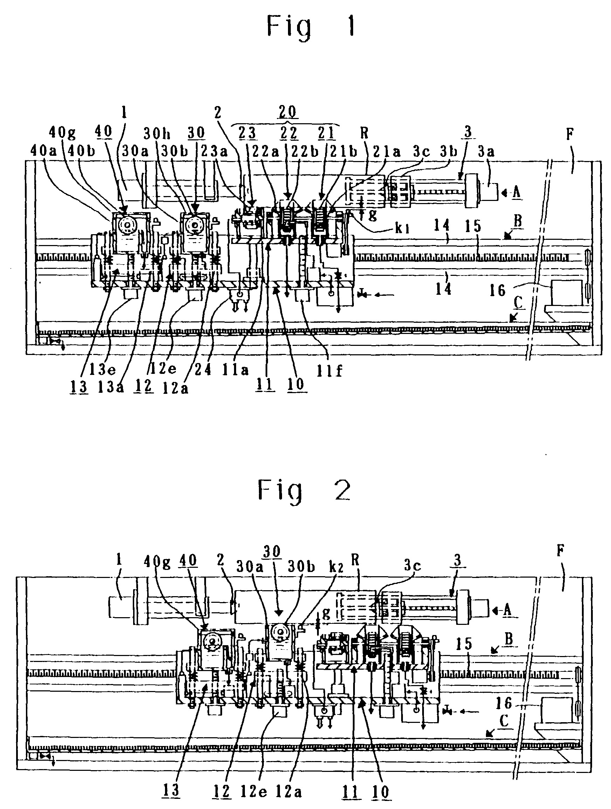

As is shown in Figures 1 through 3, the photosensitive film coating device for plate rolls includes; (i) a plate roll chucking and rotating means A (hereinafter referred to as a "chucking means A") that holds a plate roll R at both ends in a horizontal position and causes the plate roll R to rotate at a predetermined speed, (ii) a multi-surface-treatment means B (hereinafter referred to as a "treatment means B") that is located beneath the chucking means A and alternately performs a pretreatment, a photosensitive film coating treatment, and a protective film coating treatment on the plate roll R, and (iii) a drain pan C which is located beneath the treatment means B. These three basic elements are installed in a frame F consisting of a floor plate, left and right side plates and a front plate.

The chucking means A consists of a spindle chuck 2 which is rotatably driven by a first motor 1, and an X table device 3 which is composed of a second motor 3a, an X table 3b, and a tail chuck 3c. The tail chuck 3c is rotatably provided on the X table 3b, and the X table 3b is slid on the X table device 3 by means of the second motor 3a.

The thus comprised chucking means A holds both ends of the plate roll R in a horizontal position and rotates the plate roll R at a predetermined speed. For example, the circumferential speed of the plate roll R is set at 0.3 mm/sec.

The treatment means B consists of three separate table devices 11, 12, and 13. The three separate tables are installed on a common table 10, and alternately raised and lowered in the perpendicular direction. The common table 10 installed beneath the plate roll R is capable of making a reciprocating motion in the direction of the length of the plate roll.

On the three separate table devices 11, 12, and 13, a pretreatment means 20, a photosensitive film coating means 30, and a protective film coating means 40 are respectively installed.

A first proximity sensor k1, a second proximity sensor k2, and a third proximity sensor k3 are respectively provided on the three separate table devices 11, 12, and 13 so as to detect the both ends of the plate roll and a gap (g) between the sensors and the surface of the plate roll R.

The common table 10 is L-shaped, and a linear guide (not shown) is installed on the back surface of the vertical part of the common table 10. The linear guide is engaged with and guided by a horizontal guide 14. A nut runner (not shown), that is also installed on the back surface of the vertical part of the common table 10, is engaged with a screw shaft 15 rotatably driven by a third motor 16 so that the common table 10 is caused to move back and forth.

The third motor 16 is driven to move the common table 10 forward (i.e., move to the left in the drawings) after each of the first, second, and third proximity sensors detect the gap (g) between each of the sensors and one end (i.e., the spindle-chuck end) of the plate roll R.

The third motor is stopped when the common table device 10 moves a predetermined distance in the forward direction after the other end (i.e., the tail-chuck end) of the plate roll is detected by each of the first, second, and third proximity sensors.

Then, after a predetermined period of time has elapsed, the third motor reversely rotates so that the common table device 10 is caused to move a predetermined return stroke.

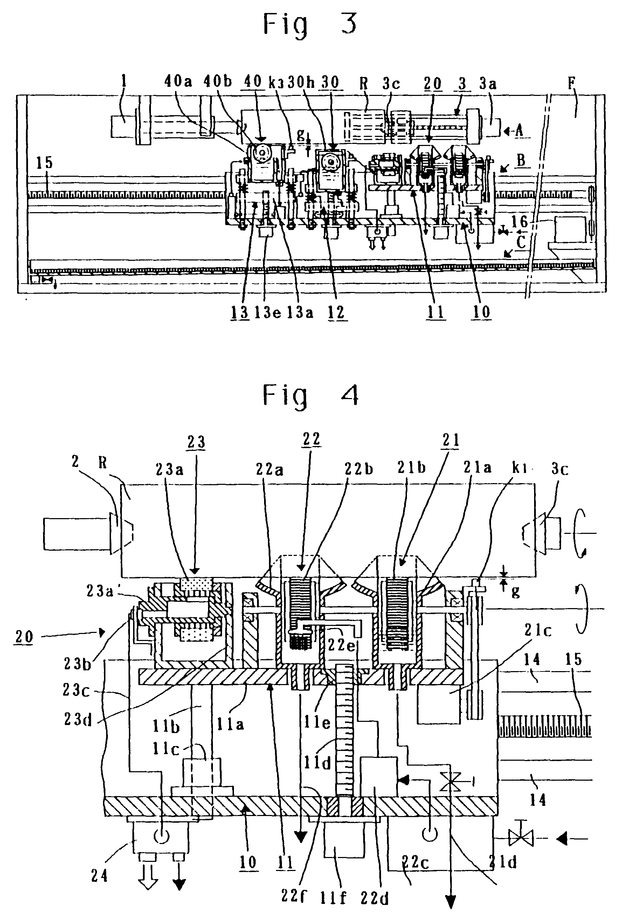

As is shown in Fig. 4, the first separate table device 11 is comprised of a table 11a, a rod 11b, a tube-form guide 11c that is provided on the common table 10, a nut 11e that is fastened to the table 11a, a screw shaft 11d engaged with the nut 11e, and a fourth motor 11f that is provided on the under surface of the common table 10.

The rod 11b, which is vertically installed on the under surface of the table 11a, passes through the tube-form guide 11c. The screw shaft 11d, which is supported on the common table 10, is rotatably driven by the fourth motor 11f.

With such a structure, the table 11a is moved upward and downward by the fourth motor 11f.

The pretreatment means 20 consists of (i) a cleaning means 21 which cleans the plate roll R, (ii) a brush-type water rinsing means 22 (hereinafter referred to as a "rinsing means") which performs a water rinsing operation following the cleaning operation, and (iii) a sponge plate roll contact-type moisture removal means 23 (hereinafter referred to as a "moisture removal means") which removes moisture from the plate roll R after the water rinsing operation. These three means 21, 22 and 23 are installed on the table 11a of the first separate table device 11.

The cleaning means 21 performs a cleaning operation by bringing a first brush roll 21b, which is immersed in a cleaning agent (neutral detergent) in a first mini-tank 21a, into contact with the plate roll R while the brush roll 21b is rotated by a seventh motor 21c installed on the table 11a.

The cleaning agent in the first mini-tank 21a is replenished when the amount drops below a predetermined level or when the cleaning capacity of the cleaning agent decreases. A valve-equipped drain outlet 21d is installed in the first mini-tank 21a for replacement of the cleaning agent.

The rinsing means 22 performs a water rinsing operation by causing a second brush roll 22b being rotated by the seventh motor 21c and having bristles washed by washing water contained in a second mini-tank 22a to contact the portion of the plate roll R that has been subjected to the cleaning operation. Tap water is used for washing the second brush roll 22b that is introduced into a hot water production tank 22c installed on the common table 10; wherein the tap water is heated to a predetermined temperature. The thus heated water is pumped upwardly by a pump 22d via a hose and sprayed onto the bristles of the second brush roll 22b by a shower nozzle 22e. The water in the second mini-tank 22a is discharged via a drain outlet 22f and flows downward into the drain pan C.

The moisture removal means 23 is comprised of a sponge roll 23a, a hollow shaft 23a', a rotary joint tube 23b, a hose 23c, a bracket 23d, and a moisture removal device 24 which is, for example, an air suction means. The sponge roll 23a is provided on the outer circumference of the hollow shaft 23a' that is supported by the bracket 23d at both ends. The open end of the hollow shaft 23a' is connected to the moisture removal device 24 installed on the under surface of the common table 10. The hollow shaft 23a' has an opening on the circumference of the hollow shaft so that air is sucked into the hollow part of the hollow shaft 23a' from outer circumference of the sponge roll 23a by means of the moisture removal device 24.

The sponge roll 23a is brought into contact with the portion of the plate roll R that has been subjected to the water rinsing operation.

As a result of this contact, the sponge roll 23a is caused to undergo a passive rotation. The moisture adhering to the plate roll R is sucked into the interior of the sponge roll 23a along with air by the suction action of the moisture removal device 24. The moisture thus captured by the moisture removal device 24 flows down into the drain pan C.

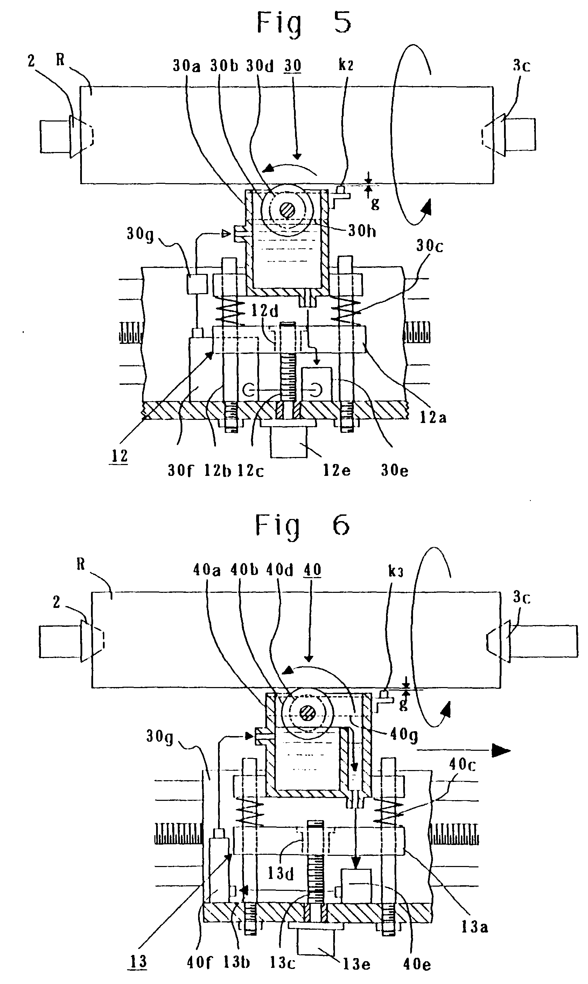

As is shown in Fig. 5, the second separate table device 12 includes a table 12a, rods 12b, a screw shaft 12c, a nut 12d, and a fifth motor 12e.

The table 12a, which is guided by the rods 12b vertically provided on the common table 10, is supported by the screw shaft 12c by means of the nut 12d. The screw shaft 12c is rotatably driven by the fifth motor 12e installed on the under surface of the common table so that the table 12a is raised and lowered.

The photosensitive film coating means 30 consists of a third mini-tank 30a which is provided on the table 12a by means of springs 30c, a photosensitive film coating roll 30b which is installed inside the third mini-tank 30a, and an eighth motor 30d which is provided on the outside of the third mini-tank 30a.

A circulation system of the photosensitive film coating means is composed of a pump 30e, an auxiliary tank 30f, and a filter 30g. Photosensitive liquid stored in the third mini-tank is circulated for several minutes, for example, approximately 10 minutes, before the photosensitive film coating treatment so that the photosensitive liquid is agitated and air bubbles contained in the liquid are eliminated by letting the air bubbles float upwardly.

Accordingly, the photosensitive liquid is maintained in a uniform state. This circulation of the photosensitive liquid is not performed during the coating operation.

The third mini-tank 30a has a lid 30h which can seal the opening of the third mini-tank 30a. When the coating operation is initiated, the lid 30h is automatically opened, and when the coating operation is completed, the lid 30h is automatically closed.

The photosensitive film coating roll 30b is caused to rotate in contact with the plate roll R so that (i) the axial direction of the photosensitive film coating roll 30b crosses the axial direction of the plate roll R, and (ii) the photosensitive liquid carried on the surface of the photosensitive film coating roll 30b faces the direction of the advancement of the common table 10.

Accordingly, the photosensitive film is coated in the form of a spiral, and the adjacent tracks of the spiral are caused to overlap by 70 to 90%, so that a rubbed-in coating is completely performed. In this way, the generation of pinholes where the photosensitive film is not coated is completely avoided. Thus, a photosensitive film with a uniform thickness is coated in a continuous manner along the entire length of the plate roll R.

The photosensitive film coating roll 30b, which is made by foaming a resin such as polyvinyl alcohol, etc, is driven at a predetermined speed, for example, 60rpm. The size of the photosensitive film coating roll is, for example, 130mm in diameter and 35mm in the length. In such a condition, the transit speed of the common table 10 in a horizontal direction is determined so that a finished width is, for example, approximately 7mm per rotation of the plate roll.

Fig. 6 shows the third separate table device 13 that is comprised of a table 13a, the rods 13b, a screw shaft 13c, a nut 13d, and a sixth motor 13e.

The table 12a, which is guided by the rods 13b vertically provided on the common table 10, is supported by the screw shaft 13c by means of the nut 13d. The screw shaft 13c is rotatably driven by the sixth motor 13e installed on the under surface of the common table, so that the table 13a is raised and lowered.

The protective film coating means 40 consists of a fourth mini-tank 40a (constructed with an over flow structure), a protective film coating roll 40b, springs 40c, and a ninth motor 40d.

The fourth mini-tank 40a, which is provided on the table 13a via the springs 40c, is supported along the rods 13b of the third separate table. The protective film coating roll 40b installed in the fourth mini-tank 40a is driven by the ninth motor 40d provided outside of the fourth mini-tank 40a.

A circulation system of the protective film coating means 40 is composed of a pump 40e and a filter 40f.

The protective film liquid (hereinafter) referred to as "protective liquid"), which is stored in the fourth mini-tank 40a and its over-flow tank, is circulated for several minutes before the protective film coating treatment till the end of this treatment. Accordingly, the protective liquid is agitated and kept in a uniform state.

The protective liquid is a transparent macromolecules agent such as polyvinyl alcohol, etc., which shows an oxygen-blocking effect when stiffened.

The protective film is used so as to maintain an original sensitivity of the photosensitive film.

The fourth mini-tank 40a has a lid 40g which can seal the opening of the fourth mini-tank 40a. When the coating operation is initiated, the lid 40g is automatically opened, and when the coating operation is completed, the lid 40g is automatically closed.

The protective film coating roll 40b is caused to rotate in contact with the plate roll R such that (i) the axial direction of the protective film coating roll 40b crosses the axial direction of the plate roll R, and (ii) the carrying of the protective liquid on the protective film coating roll 40b occurs on the forward side of the roll 40b with respect to the direction of the advancement of the common table 10.

Accordingly, a transparent protective film is coated in the form of a spiral, and the adjacent tracks of the spiral overlap by 70 to 90%, so that a rubbed-in coating is thoroughly accomplished. In this way, the generation of pinholes where the protective film is not coated is completely avoided, and a protective film with a uniform thickness is applied in a continuous manner along the entire length of the plate roll R.

The protective film coating roll 40b, which is also made by foaming a resin such as polyvinyl alcohol, etc, is driven at a predetermined speed, for example, 60rpm. The size of the protective film coating roll is, for example, 130mm in diameter and 35mm in the length. In such a condition, the transit speed of the common table 10 in a horizontal direction is determined so that a finished width is, for example, approximately 7mm per rotation of the plate roll R.

Next, the operation of the embodiment of the photosensitive film coating device for plate rolls, that are to be made into printing plates, provided by the present invention will be described:

The plate roll R is positioned horizontally between the spindle chuck 2 and the tail chuck 3. When a "chucking start" button (not shown) is pressed, the second motor 3a is driven, and the plate roll R is held at both ends by the spindle chuck 2 and tail chuck 3.

When the "operation start" button (not shown) is pressed, the pretreatment, photosensitive film coating treatment and protective film coating treatment are automatically performed in that order.

First, the pretreatment is initiated as shown in Figure 1. The detail is shown in Fig. 4. The first motor 1 is driven and the plate roll R is rotated. The rotation of the plate roll R is continued throughout the entire operation and for approximately an additional 10 minutes following the completion of the protective film coating treatment which is last.

Prior to the initiation of the pretreatment, the first brush roll 21b is set at the initial position that corresponds to one end of the plate roll R. The seventh motor 21c is driven so that the first brush roll 21b and second brush roll 22b are caused to rotate, and the air suction action of the moisture removal device 24 is started.

Then, the fourth motor 11f is driven so that the table 11a is elevated and the first brush roll 21b appropriately contacts the surface of the end of the plate roll R.

When the first brush roll 21b contacts the surface of the plate roll R, the first proximity sensor k1 detects the gap between the sensor k1 and the surface of the plate roll R, and the fourth motor is stopped by the signal from the first proximity sensor k1.

Then the third motor 16 is driven by the signal from the first proximity sensor k1 so that the common table device 10 is moved toward the other end of the plate roll R. Thus, the second brush roll 22b rotates in contact with the plate roll R following the first brush roll 21b, and the sponge plate roll 23a rotates in contact with the plate roll R following the second brush roll 22b.

The first brush roll 21b and the second brush roll 22b rotate against the plate roll R, while the sponge plate roll 23a rotates passively with the plate roll R. The first brush roll 21b applies the cleaning agent in the first mini-tank 21a to the surface of the plate roll R in a spiral pattern without any remaining gaps, so that the entire surface of the plate roll R is subjected to a continuous cleaning process. Any cleaning agent scattered in this process is retrieved inside the first mini-tank 21a through the top opening.

Using water, the second brush roll 22b rinses the cleaning agent away from the portion of the plate roll R that has been subjected to the cleaning operation.

During this rinsing operation, the bristles of the second brush roll 22b are washed by the washing water stored in the second mini-tank 22a. Any water scattered in this process is recovered in the second mini-tank 22a through the top opening.

The sponge plate roll 23a performs a moisture removal operation via an air suction by the moisture removal means 24 on the portion of the plate roll R that has been subjected to the water rinsing operation.

The common table device 10 moves to the right (in the drawings), and when the first proximity sensor k1 passes the other end of the plate roll R, the first proximity sensor k1 detects the other end of the plate roll R. The third motor 16 continues to rotate for a predetermined number of revolutions after the end of the plate roll is detected and until the sponge roll 23a reaches the other end of the plate roll R. The pretreatment is thus completed.

Next, the seventh motor 21c and the moisture removal device 24 are stopped, the pretreatment means 20 is moved back to the initial position by the reverse rotation of the fourth motor 11f, and the third motor 16 reversely rotates until the photosensitive film coating roll 30b reaches a position corresponding to the end of the plate roll R.

Next, the photosensitive film coating treatment is initiated as shown in Figure 2. The detail is shown in Figure. 5.

The pump 30e is driven for several minutes from the initiation of the pretreatment to an intermediate point of the pretreatment process so that the photosensitive liquid is circulated through out the circulation system, after which the liquid is left as is for several minutes. As a result, air bubbles in the photosensitive liquid contained in the third mini-tank 30a float upward and are eliminated. The photosensitive liquid is thus maintained in a uniform state.

The lid 30h is then automatically opened, and the photosensitive film coating roll 30b is rotated by the eighth motor 30b, and the fifth motor 12e is driven to elevate the table 12a. At the point where the photosensitive film coating roll 30b is placed in an appropriate contact with one end of the plate roll R, the second proximity sensor k2 detects the gap (g) between itself and the surface of the plate roll R, the fifth motor 12e is stopped by a signal generated by the second proximity sensor k2, and the third motor 16 is driven by the signal of the second proximity sensor k2 so that the common table device 10 is caused to move toward the other end of the plate roll R.

Next, the photosensitive film coating roll 30b is caused to rotate in contact with the plate roll R such that (i) the axial direction of the photosensitive film coating roll 30b crosses the axial direction of the plate roll R, and (ii) the carrying of the photosensitive liquid on the photosensitive film coating roll 30b occurs on the forward side of the plate roll 30b with respect to the direction of the advancement of the plate roll 30b.

As a result, the photosensitive film is coated in the form of a spiral, and adjacent tracks of this spiral are caused to overlap by 70 to 90%, so that a rubbed-in coating is thoroughly coated.

Accordingly, the generation of pinholes where the photosensitive film is not applied is completely avoided, and a photosensitive film with a uniform thickness is coated in a continuous manner along the entire length of the plate roll R.

The common table device 10 moves to the right in the drawings, and when the second proximity sensor k2 passes the other end of the plate roll R, the sensor k2 detects the other end of the plate roll R. The third motor 16 makes a predetermined number of revolutions after the end of the plate roll is detected, and when the photosensitive film coating roll 30b reaches the other end of the plate roll R, the third motor 16 is stopped.

Subsequently, the eighth motor 30d is stopped, and the photosensitive film coating means 30 is moved back to the initial position by the reverse rotation of the fifth motor 12e. After the lid is automatically closed, the third motor 16 reversely rotates until the protective film coating roll 40b reaches a position corresponding to the end of the plate roll R.

The photosensitive film coating treatment is thus completed.

Following the completion of the photosensitive film coating treatment, the photosensitive film dries for approximately 10 minutes. After this drying time, the protective film coating treatment is initiated as shown in Figure 3. The detail is shown in Figure 6.

The plate roll R is kept rotating between the completion of the photosensitive film coating treatment and the initiation of the protective film coating treatment, so that there is no bias in the thickness of the photosensitive film.

A few minutes prior to the completion of the photosensitive film coating treatment, the pump 40e of the protective film coating means 40 is driven so that the protective liquid is circulated through out the circulation system.

In this way, the protective liquid in the fourth mini-tank 40a is maintained in a uniform state. The lid 40g is automatically opened, and the ninth motor 40d is driven so that the protective film coating roll 40b is caused to rotate.

Furthermore, the sixth motor 13e is driven to raise the table 13a. At the point where the protective film coating roll 40b is placed in an appropriate contact with one end of the plate roll R, the third proximity sensor k3 detects the gap (g) between itself and the surface of the plate roll R, and the sixth motor 13e is stopped by a signal generated by the third proximity sensor k3.

As a result of this signal, the third motor 16 is driven so that the common table device 10 is caused to move toward the other end of the plate roll R. A protective film is thus coated on the plate roll R. In this case, the protective film coating roll 40b is caused to rotate in contact with the plate roll R such that (i) the axial direction of the protective film coating roll 40b crosses the axial direction of the plate roll R, and (ii) the carrying of the protective liquid on the protective film coating roll 40b occurs on the forward side of coating roll 40b with respect to the direction of the advancement of the roll 40b.

As a result, the protective film is coated in the form of a spiral, and adjacent tracks of this spiral are caused to overlap, so that a rubbed-in coating is thoroughly coated.

Accordingly, the generation of pinholes where no coating is applied is completely avoided, and a protective film with a uniform thickness is applied in a continuous manner along the entire length of the plate roll R.

The common table device 10 moves to the right in the drawings, and when the third proximity sensor k3 passes the other end of the plate roll R, the third proximity sensor k3 detects the other end of the plate roll R. The third motor 16 makes a predetermined number of revolutions after the end of the plate roll is detected. When the protective coating roll 40b reaches the other end of the plate roll R, the third motor 16 is stopped, and the protective film coating means 40 is moved back to the initial position by the reverse rotation of the sixth motor 13e. After the lid is automatically closed, the third motor 16 reversely rotates until the first brush roll 21b of the cleaning means 21 of the pretreatment means 20 reaches at a position corresponding to the end of the plate roll R.

As seen in the above, the pretreatment, the photosensitive film coating treatment and the protective film coating treatment are performed in a completely automatic manner.

The plate roll R is rotated for approximately 10 minutes following the completion of the protective film coating treatment, so that no bias is generated in the thickness of the protective film.

Approximately 10 minutes after the protective film is dried, the plate roll R is released from the chucks and subjected to a laser exposure.

In the present invention, since a pretreatment, a photosensitive film coating, and a protective film coating are performed by a single device, the device does not occupy a large space, and the price of the device is lower than conventional devices.

In addition, the plate roll is successively "scanned" by the three means, i.e., the pretreatment means, the photosensitive film coating means, and the protective film coating means. Therefore, the device can make plate rolls which are coated by the photosensitive film and the protective film with a uniform thickness.

Furthermore, according to the present invention, it is not necessary to replace the plate roll each time the pretreatment, the photosensitive film coating and the protective film coating are performed, so that it takes little handling time and labor.

## Claims

1. A photosensitive film coating device for plate rolls that are to be made into printing plates characterized in that said photosensitive film coating device comprises a plate roll chucking and rotating means (A) which chucks the plate roll (R) at both ends in a horizontal position and rotates said plate roll (R) at a prescribed rpm, and a multi-surface treatment means (B) which alternately performs a pretreatment, a photosensitive film coating treatment and a protective film coating treatment, wherein,
said multi-surface treatment means (B) has three separate table devices which can be alternately raised and lowered, said means being installed on a single common table device (10) which is positioned beneath said plate roll (R) and is capable of making a reciprocating motion in the direction of the length of the plate roll surface and on said three separate table devices (11,12,13) being respectively provided with a pretreatment means (20), a photosensitive film coating means (30) and a protective film coating means (40) in which:
said pretreatment means (20) consists of:
a cleaning means (21) which performs a cleaning operation by causing a first brush roll (21b) which is immersed in a cleaning agent contained in a first mini-tank (21a) to contact the plate roll (R);
a brush type water rinsing means (22) which performs a water rinsing operation by causing a second brush roll (22b), that has bristles washed by washing water inside a second mini-tank (22a) to contact the portion of the plate roll that has been subjected to the cleaning operation; and
a sponge plate roll contact-type moisture removal means (23) which performs a moisture removal operation by causing a sponge plate roll (23a), which is connected to an air suction means (24) so that air suction can be created from the surface of said sponge plate roll (23a) toward the interior of said sponge plate roll (23a), to contact the portion of the plate roll (R) that has been subjected to the water rinsing operation;
said photosensitive film coating means (30) coating a photosensitive film on said plate roll (R) by causing a photosensitive film coating roll (30b) immersed in a photosensitive liquid contained in a third mini-tank (30a) to rotate in contact with the plate roll (R) such that the axial direction of said photosensitive film coating roll (30b) crosses the axial direction of the plate roll (R) that is to be made into a printing plate as seen in a plan view and that a carrying of said photosensitive liquid on the photosensitive film coating roll (30b) occurs on the forward side of said coating roll with respect to the direction of advance of said coating roll; and
said protective film coating means (40) applies a protective film on said plate roll (R) by causing a protective film coating roll (40b) immersed in a transparent photosensitive film protective liquid contained in a fourth mini-tank (40a) to rotate in contact with the plate roll (R) such that the axial direction of the protective film coating roll (40b) crosses the axis direction of the plate roll (R) when viewed from top, and that a carrying of the photosensitive film protective liquid on the protective film coating roll (40b) occurs on the forward side of said coating roll with respect to the direction of advancement of said coating roll.

2. A photosensitive film coating device for a plate roll comprising:
a roll chucking means (A) comprised of a spindle chuck (2) a tail chuck (3c) and motors (1,3a), and said chucking means (A) holding and rotating said plate roll (R), and
a multi-treatment means (B) comprised of a pretreatment means (20), a photosensitive film coating means (30) and a protective film coating means (40) which are respectively provided on three separate table devices (11,12,13) that can be raised and lowered relative to said plate roll, said multi-treatment means being installed on a single common table device (10) which is positioned beneath said plate roll (R) and is capable of making a reciprocating motion in the direction of the length of the plate roll surface, wherein,
said pretreatment means (20) comprises a cleaning means (21), a rinsing means (22) and a moisture removal means (23), said pretreatment means (20) consecutively cleaning said plate roll (R), rinsing said plate roll (R) and then removing a moisture from said plate roll (R),
said photosensitive film coating means (30) consists of a photosensitive film coating roll (30b) and a photosensitive liquid tank (30a), said coating means coating photosensitive liquid on said plate roll (R) following a pretreatment operation performed by said pretreatment means (20), and
said protective film coating means (40) consists of a protective film coating roll (40b) and a protective liquid tank (40a), said coating means coating protective liquid on said plate roll (R) following a photosensitive liquid coating operation performed by said photosensitive film coating means (30).

3. A photosensitive film coating device, according to claim 2, wherein said spindle chuck (2) is connected to one of said motors (1,3a), and said tail chuck (3c) is rotatably provided on an X table which is installed on a X table device (3) so as to be slid by the other of said motors (1,3a) so that said plate roll (R) is horizontally held between said spindle chuck (2) and said tail chuck (3c) and rotated at a predetermined speed.

4. A photosensitive film coating device, according to claim 2, wherein said cleaning means (21) is comprised of a first mini-tank (21a) in which a cleaning agent is stored and a first brush (21b) immersed in said cleaning agent so that a cleaning of said plate roll (R) is performed by causing said first brush (21b) to contact said plate roll (R).

5. A photosensitive film coating device, according to claim 2, wherein said rinsing means (22) is comprised of a second mini-tank (22a) in which a rinsing water is stored and a second brush (22b) immersed in said rinsing water so that a rinsing of said plate roll (R) is performed by causing said second brush (22b) to contact said plate roll (R).

6. A photosensitive film coating device, according to claim 2, wherein said moisture removal means (23) is comprised of a sponge roll (23a) a hollow shaft (23a') and a moisture removal device (24), said sponge roll (23a) being connected to said moisture removal device (24) by means of said hollow shaft (23a') so that a moisture removing of said plate roll (R) is performed by causing said sponge roll (23a) to contact said plate roll (R).

7. A photosensitive film coating device, according to claim 2, wherein said photosensitive film coating roll (30b) is contacted and rotated with said plate roll (R) such that axial direction of said photosensitive film coating roll (30b) crosses axial direction of said plate roll (R), and a carrying of said photosensitive liquid on said photosensitive film coating roll (30b) occurs on a forward side of said photosensitive film coating roll (30b) with respect to the direction of advancement of said photosensitive film coating roll (30b).

8. A photosensitive film coating device, according to claim 2, wherein said protective film coating roll (40b) is contacted and rotated with said plate roll (R) such that axial direction of said protective film coating roll (40b) crosses axial direction of said plate roll (R) and a carrying of said protective liquid on said protective film coating roll (40b) occurs on a forward side of said protective film coating roll (40b) with respect to the direction of advancement of said protective film coating roll (40b).

## Patentansprüche

1. Vorrichtung zur Beschichtung eines lichtempfindlichen Films für Plattenzylinder, die zu Druckplatten verarbeitet werden sollen, dadurch gekennzeichnet, daß die Vorrichtung zur Beschichtung eines lichtempfindlichen Films eine Plattenzylinder-Spann- und Drehvorrichtung (A) umfaßt, die den Plattenzylinder (R) an beiden Enden in einer horizontalen Position einspannt und ihn mit einer vorgeschriebenen Drehzahl dreht, und eine Mehrfach-Oberflächenbehandlungseinrichtung (B), die abwechselnd eine Vorbehandlung, eine Behandlung durch Beschichtung mit einem lichtempfindlichen Film und eine Beschichtung mit einem Schutzfilm durchführt, wobei
die Mehrfach-Oberflächenbehandlungseinrichtung (B) drei eigene Tischvorrichtungen besitzt, die abwechselnd gehoben und gesenkt werden können, die Einrichtung auf einer einzigen gemeinsamen Tischvorrichtung (10) montiert ist, die unter dem Plattenzylinder (R) angeordnet ist und in Längsrichtung der Plattenzylinderoberfläche eine Hin- und Herbewegung ausführen kann, und auf den drei eigenen Tischvorrichtungen (11,12,13) jeweils eine Vorbehandlungseinrichtunc (20), eine Einrichtung zur Beschichtung mit einem lichtempfindlichen Film (30) und eine Einrichtung zur Beschichtung mit einem Schutzfilm (40) vorgesehen sind, wobei
die Vorbehandlungseinrichtung (20) aus folgendem besteht:
einer Reinigungseinrichtung (21), die einen Reinigungsvorgang durchführt, indem eine erste Bürstenwalze (21b), die in ein in einem ersten Kleintank (21a) enthaltenes Reinigungsmittel getaucht ist, veranlaßt wird, mit dem Plattenzylinder (R) in Kontakt zu treten;
einer bürstenartigen Wasserspüleinrichtung (22), die einen Wasserspülvorgang ausführt, indem eine zweite Bürstenwalze (22b), die in einem zweiten Kleintank (22a) mit Waschwasser gewaschene Borsten besitzt, mit dem Teil des Plattenzylinders in Kontakt gebracht werden, welcher dem Reinigungsvorgang unterzogen worden ist; und
einer Schwamm-Plattenzylinder-Kontakteentfeuchtungseinrichtung (23), die einen Entfeuchtungsvorgang ausführt, indem sie einen Schwamm-Plattenzylinder (23a), der mit einer Luftansaugeinrichtung (24) verbunden ist, mit dem Teil des Plattenzylinders (R), welcher dem Wasserspülvorgang unterzogen worden ist, in Kontakt bringt, so daß von der Oberfläche des Schwamm-Plattenzylinders (23a) in das Innere des Schwamm-Plattenzylinders (23a) eine Luftsaugwirkung erzeugt werden kann;
wobei die Einrichtung zur Beschichtung mit einem lichtempfindlichen Film (30), die auf den Plattenzylinder (R) einen lichtempfindlichen Film aufträgt, indem ein mit einem lichtempfindlichen Film beschichtender Zylinder (30b), der in eine in einem dritten Kleintank (30a) enthaltene, lichtempfindliche Flüssigkeit eingetaucht ist, in Kontakt mit dem Plattenzylinder (R) in Rotation versetzt wird, so daß die axiale Richtung des mit einem lichtempfindlichen Film beschichtenden Zylinders (30b) die axiale Richtung des Plattenzylinders (R) kreuzt, der zu einer Druckplatte gefertigt werden soll, wie in einem Grundriß ersichtlich ist, und ein Auftragen der lichtempfindlichen Flüssigkeit auf den mit einem lichtempfindlichen Film beschichtenden Zylinder (30b) auf den In bezug auf die Drehrichtung des Beschichtungszylinders vorderen Teil des Beschichtungszylinders stattfindet; und
die Einrichtung zur Beschichtung mit einem Schutzfilm (40) auf den Plattenzylinder (R) einen Schutzfilm aufbringt, indem sie einen Schutzfilm-Beschichtungszylinder (40b), der in eine transparente, mit einem lichtempfindlichen Film beschichtende, in einem vierten Kleintank (40a) enthaltene, Flüssigkeit getaucht ist, in Kontakt mit dem Plattenzylinder (R) in Rotation versetzt, so daß die axiale Richtung des Schutzfilm-Beschichtungszylinders (40b) die axiale Richtung des Plattenzylinders (R) von oben gesehen kreuzt und ein Auftragen der den lichtempfindlichen Film schützenden Flüssigkeit auf den mit Schutzfilm-Beschichtungszylinder (40b) auf den in bezug auf die Drehrichtung des Beschichtungszylinders vorderen Teil des Beschichtungszylinders stattfindet.

2. Vorrichtung zur Beschichtung eines lichtempfindlichen Films für einen Plattenzylinder mit:
einer Zylinder-Spannvorrichtung (A), die aus einem Spindel-Spannfutter (2), einem Gegen-Spannfutter (3c) und Motoren (1, 3a) besteht, wobei die Spannvorrichtung (A) den Plattenzylinder (R) trägt und dreht, und
einer Vielfach-Behandlungseinrichtung (B), die aus einer Vorbehandlungseinrichtung (20), einer Einrichtung zur Beschichtung mit einem lichtempfindlichen Film (30) und einer Einrichtung zur Beschichtung mit einem Schutzfilm (40) besteht, welche jeweils auf drei eigenen Tischvorrichtungen (11,12,13) bereitgestellt sind, die relativ zu dem Plattenzylinder angehoben und gesenkt werden können, wobei die Vielfach-Behandlungseinrichtung auf einer einzigen gemeinsamen Tischvorrichtung (10) aufgebaut ist, die unterhalb des Plattenzylinders (R) angeordnet ist und eine Hin- und Herbewegung in Längsrichtung der Plattenzylinder-Oberfläche ausführen kann, wobei
die Vorbehandlungseinrichtung (20) eine Reinigungseinrichtung (21), eine Spüleinrichtung (22) und eine Einrichtung zum Entfernen von Feuchtigkeit (23) umfaßt, die Vorbehandlungseinrichtung (20) aufeinanderfolgend den Plattenzylinder (R) reinigt, den Plattenzylinder (R) spült und dann die Feuchtigkeit von dem Plattenzylinder (R) entfernt,
die Einrichtung zur Beschichtunc mit einem lichtempfindlichen Film (30) aus einem mit lichtempfindlichem Film beschichtenden Zylinder (30b) und einem Behälter für lichtempfindliche Flüssigkeit (30a) besteht, die Beschichtungseinrichtung nach einem von der Vorbehandlungseinrichtung (20) durchgeführten Vorbehandlungsvorgang auf dem Plattenzylinder (R) lichtempfindliche Flüssigkeit aufträgt, und
die Einrichtung zur Beschichtung mit einem Schutzfilm (40) aus einem Schutzfilm-Beschichtungszylinder (40b) und einem Behälter für Schutzflüssigkeit (40a) besteht, wobei die Beschichtungseinrichtung nach einem Beschichtungsvorgang mit lichtempfindlicher Flüssigkeit, der von der Einrichtung zur Beschichtung mit einem lichtempfindlichen Film (30) durchgeführt wird, auf den Plattenzylinder (R) lichtempfindliche Flüssigkeit aufträgt.

3. Vorrichtung zur Beschichtung eines lichtempfindlichen Films nach Anspruch 2, wobei das Spindel-Spannfutter (2) mit einem der Motoren (1,3a) verbunden ist und das Gegen-Spannfutter (3c) auf einem X-Tisch drehbar vorgesehen ist, der auf einer X-Tischvorrichtung (3) so montiert ist, daß er durch die übrigen Motoren (1,3a) verschoben wird, so daß der Plattenzylinder (R) zwischen dem Spindel-Spannfutter (2) und dem Gegen-Spannfutter (3c) horizontal gehalten und mit einer vorgegebenen Geschwindigkeit gedreht wird.

4. Vorrichtung zur Beschichtung eines lichtempfindlichen Films nach Anspruch 2, wobei die Reinigungseinrichtung (21) aus einem ersten Kleintank (21a) besteht, in dem ein Reinigungsmittel gelagert wird und in dem Reinigungsmittel eine erste Bürste (21b) eingetaucht ist, so daß ein Reinigen des Plattenzylinders (R) durchgeführt wird, indem die erste Bürste (21b) mit dem Plattenzylinder (R) in Kontakt gebracht wird.

5. Vorrichtung zur Beschichtung eines lichtempfindlichen Films nach Anspruch 2, wobei die Spüleinrichtung (22) aus einem zweiten Kleintank (22a) besteht, in dem Spülwasser gelagert wird und in dem Spülwasser eine zweite Bürste (22b) eingetaucht ist, so daß ein Spülen des Plattenzylinders (R) durchgeführt wird, indem die zweite Bürste (22b) mit dem ?lattenzylinder (R) in Kontakt gebracht wird.

6. Vorrichtung zur Beschichtung eines lichtempfindlichen Films nach Anspruch 2, wobei die Einrichtung zum Entfernen von Feuchtigkeit (23) aus einer Schwammrolle (23a), einer Hohlwelle (23a') und einer Einrichtung zum Entfernen von Feuchtigkeit (24) besteht, die Schwammrolle (23a) über die Hohlwelle (23a') mit der Einrichtung zum Entfernen von Feuchtigkeit (24) verbunden ist, so daß ein Entfernen von Feuchtigkeit von dem Plattenzylinder (R) durchgeführt wird, indem die Schwammrolle (23a) mit dem Plattenzylinder (R) in Kontakt gebracht wird.

7. Vorrichtung zur Beschichtung eines lichtempfindlichen Films nach Anspruch 2, wobei der mit einem lichtempfindlichen Film beschichtende Zylinder (30b) mit dem Plattenzylinder (R) in Kontakt gebracht und in Rotation versetzt wird, so daß die axiale Richtung des mit einem lichtempfindlichen Film beschichtenden Zylinders (30b) die axiale Richtung des Plattenzylinders (R) kreuzt und ein Übertragen der lichtempfindlichen Flüssigkeit auf den in bezug auf die Drehrichtung des mit einem lichtempfindlichen Film beschichtenden Zylinders (30b) vorderen Teil dieses Zylinders (30b) stattfindet.

8. Vorrichtung zur Beschichtung eines lichtempfindlichen Films nach Anspruch 2, wobei der Schutzfilm-Beschichtungszylinder mit dem Plattenzylinder (R) in Kontakt gebracht und in Rotation versetzt wird, so daß die axiale Richtung des Zylinders zum Beschichten mit einem Schutzfilm (40b) die axiale Richtung des Plattenzylinders (R) kreuzt und ein Übertragen der schützenden Flüssigkeit auf den in bezug auf die Drehrichtung des Zylinders zum Beschichten mit einer Schutzfilm (40b) vorderen Teil dieses Zylinders (40b) stattfindet.

## Revendications

1. Appareil d'enduction de film photosensible pour cylindres de plaque destinés à être convertis en plaques d'impression, caractérisé en ce que ledit appareil d'enduction de film photosensible comprend des moyens de serrage avec mandrin et d'entraînement en rotation de cylindre de plaque (A) qui maintiennent le cylindre de plaque (R) au niveau de ses deux extrémités en une position horizontale et entraîne ledit cylindre de plaque (R) en rotation à un nombre de tours/min. défini, et des moyens de traitement multisurface (B) qui effectuent alternativement un prétraitement, un traitement d'enduction de film photosensible et un traitement d'enduction de film protecteur, dans lequel
lesdits moyens de traitement multisurface (B) comportent trois dispositifs de tables séparés qui peuvent être alternativement levés et abaissés, lesdits moyens étant installés sur un seul et même dispositif de table commun (10) qui est positionné au-dessous dudit cylindre de plaque (R) et est capable d'effectuer un mouvement de va-et-vient dans la direction de la longueur de la surface du cylindre de plaque, et dans lequel des moyens de prétraitement (20), des moyens d'enduction de film photosensible (30) et des moyens d'enduction de film protecteur (40) sont respectivement fournis sur lesdits trois dispositifs de tables séparés (11,12,13), dans lequel :
lesdits moyens de prétraitement (20) comprennent :
des moyens de nettoyage (21) qui effectuent une opération de nettoyage en amenant un premier cylindre de brosse (21b), qui est immergé dans un agent de nettoyage contenu dans un premier mini-réservoir (21a), au contact du cylindre de plaque R ;
des moyens de rinçage à l'eau de type brosse (22) qui effectuent une opération de rinçage à l'eau en amenant un deuxième cylindre de brosse (22b), qui a des poils lavés par l'eau de lavage contenue dans un deuxième mini-réservoir (22a), au contact de la partie du cylindre de plaque qui a été soumise à l'opération de nettoyage, et
des moyens d'élimination d'humidité de type pas contact d'un cylindre de plaque spongieux (23) qui effectuent une opération d'élimination d'humidité en amenant un cylindre de plaque spongieux (23a), qui est relié à des moyens d'aspiration d'air (24) pour qu'une aspiration d'air puisse être créée depuis la surface dudit cylindre de plaque spongieux (23a) vers l'intérieur dudit cylindre de plaque spongieux (23a), au contact de la partie du cylindre de plaque R qui a été soumise à l'opération de rinçage à l'eau;
lesdits moyens d'enduction de film photosensible (30) appliquant un film photosensible sur ledit cylindre de plaque (R) en entraînant un cylindre d'enduction de film photosensible (30b), immergé dans un liquide photosensible contenu dans un troisième mini-réservoir (30a), en rotation au contact du cylindre de plaque (R) de façon que la direction axiale dudit cylindre d'enduction de film photosensible (30b) coupe la direction axiale du cylindre de plaque (R) qui doit être converti en une plaque d'impression, quand on le regarde dans une vue plane, et que le transport dudit liquide photosensible sur le cylindre d'enduction de film photosensible (30b) se produise du côté avant dudit cylindre d'enduction par rapport à la direction de déplacement dudit cylindre d'enduction ; et
lesdits moyens d'enduction de film protecteur (40) appliquent un film protecteur sur ledit cylindre de plaque (R) en entraînant un cylindre d'enduction de film protecteur (40b), immergé dans un liquide protecteur de film photosensible transparent contenu dans un quatrième mini-réservoir (40a), en rotation au contact du cylindre de plaque (R) de façon que la direction axiale du cylindre d'enduction de film protecteur (40b) coupe la direction axiale du cylindre de plaque (R), quand on le regarde de dessus, et que le transport dudit liquide protecteur de film photosensible sur le cylindre d'enduction de film protecteur (40b) se produise du côté avant dudit cylindre d'enduction par rapport à la direction de déplacement dudit cylindre d'enduction.

2. Appareil d'enduction de film photosensible pour cylindre de plaque comprenant :
des moyens de serrage de cylindre avec mandrin (A) composé d'un mandrin de broche (2), d'un mandrin de queue (3c) et de moteurs (1,3a), lesdits moyens de serrage avec mandrin (A) maintenant et entraînant en rotation ledit cylindre de plaque (R), et
des moyens de multitraitement (B) composés de moyens de prétraitement (20), de moyens d'enduction de film photosensible (30) et de moyens d'enduction de film protecteur (40) qui sont respectivement fournis sur trois dispositifs de tables séparés (11,12,13) qui peuvent être levés ou abaissés par rapport audit cylindre de plaque, lesdits moyens de multitraitement étant installés sur un seul et même dispositif de table commun (10) qui est positionné sous ledit cylindre de plaque (R) et est capable d'effectuer un mouvement de va-et-vient dans la direction de la longueur du cylindre de plaque, dans lequel
lesdits moyens de prétraitement (20) comprennent des moyens de nettoyage (21), des moyens de rinçage (22) et des moyens d'élimination d'humidité (23), lesdits moyens de prétraitement (20), successivement nettoyant ledit cylindre de plaque (R), rinçant ledit cylindre de plaque (R), puis éliminant l'humidité dudit cylindre de plaque (R),
lesdits moyens d'enduction de film photosensible (30) se composent d'un cylindre d'enduction de film photosensible (31b) et d'un réservoir de liquide photosensible (30a), lesdits moyens d'enduction appliquant le liquide photosensible sur ledit cylindre de plaque (R), après l'opération de prétraitement effectuée par les moyens de prétraitement (20), et
lesdits moyens d'enduction de film protecteur (40 se composent d'un cylindre d'enduction de film protecteur (40b) et d'un reservoir de liquide protecteur (40a), lesdits moyens d'enduction appliquant le liquide protecteur sur ledit cylindre de plaque (R) après l'opération d'enduction de liquide photosensible effectuée par lesdits moyens d'enduction de film photosensible (30).

3. Appareil d'enduction de film photosensible selon la revendication 2, dans lequel ledit mandrin de broche (2) est connecté à l'un desdits moteurs (1,3a), et ledit mandrin de queue (3c) est fourni de manière à pouvoir tourner sur une table à déplacement horizontal qui est installée sur un dispositif de table à déplacement horizontal (3) pour pouvoir être coulissé par l'autre desdits moteurs (1,3a) pour que ledit cylindre de plaque (R) soit maintenu horizontalement entre ledit mandrin de broche (2) et ledit mandrin de queue (3c) et entraîné en rotation à une vitesse prédéterminée.

4. Appareil d'enduction de film photosensible selon la revendication 2, dans lequel lesdits moyens de nettoyage (21) se composent d'un premier mini-réservoir (21a) dans lequel un agent de nettoyage est stocké et d'une première brosse (21b) immergée dans ledit agent de nettoyage pour qu'un nettoyage dudit cylindre de plaque (R) soit effectué en amenant ladite première brosse (21b) au contact dudit cylindre de plaque (R).

5. Appareil d'enduction de film photosensible selon la revendication 2, dans lequel lesdits moyens de rinçage (22) se composent d'un deuxième mini-réservoir (22a) dans lequel une eau de rinçage est stockée et d'une deuxième brosse (22b) immergée dans ladite eau de rinçage pour qu'un rinçage dudit cylindre de plaque (R) soit effectue en amenant ladite deuxième brosse (22b) au contact dudit cylindre de plaque (R).

6. Appareil d'enduction de film photosensible selon la revendication 2, dans lequel lesdits moyens d'élimination d'humidité (23) se composent d'un cylindre spongieux (23a), d'un arbre creux (23a'), et d'un dispositif d'élimination d'humidité (24), ledit cylindre spongieux (23a) étant connecté audit dispositif d'élimination d'humidité (24) au moyen dudit arbre creux (23a') pour qu'une élimination de l'humidité dudit cylindre de plaque (R) soit effectuée en amenant ledit cylindre spongieux (23a) au contact dudit cylindre de plaque (R).

7. Appareil d'enduction de film photosensible selon la revendication 2, dans lequel ledit cylindre d'enduction de film photosensible (30b) est mis en contact et entraîné en rotation avec ledit cylindre de plaque (R) de façon que la direction axiale dudit cylindre d'enduction de film photosensible (30b) coupe la direction axiale dudit cylindre de plaque (R) et que le transport dudit liquide photosensible sur le cylindre d'enduction de film photosensible (30b) se produise du côté avant dudit cylindre d'enduction de film photosensible (30b) par rapport à la direction de déplacement dudit cylindre d'enduction de film photosensible (30b).

8. Appareil d'enduction de film photosensible selon la revendication 2, dans lequel ledit cylindre d'enduction de film protecteur (40b) est mis en contact et entraîné en rotation avec ledit cylindre de plaque (R) de façon que la direction axiale dudit cylindre d'enduction de film protecteur (40b) coupe la direction axiale dudit cylindre de plaque (R) et que le transport dudit liquide protecteur sur le cylindre d'enduction de film protecteur (40b) se produise du côté avant dudit cylindre d'enduction de film protecteur (40b) par rapport à la direction de déplacement dudit cylindre d'enduction de film protecteur (40b).
